# FASCICULE DE BREVET EUROPEEN

(11) **EP 3 168 697 B1**
(45) Date de publication et mention de la délivrance du brevet: **19.08.2020**
(21) Numéro de dépôt: 16194904.5
(22) Date de dépôt: 20.10.2016
(51) Int. Cl.: B81C 1/00, G04B 45/00, G04D 3/00, G04B 19/10, B44C 1/22

(54) **PROCÉDÉ DE FABRICATION D'UNE PIÈCE À BASE DE SILICIUM AVEC AU MOINS UN MOTIF À ILLUSION D'OPTIQUE**
HERSTELLUNGSVERFAHREN FÜR EIN WERKSTÜCK AUF SILIZIUMBASIS MIT MINDESTENS EINEM MOTIV MIT OPTISCHEN TÄUSCHUNGSELEMENTEN
METHOD FOR MANUFACTURING A SILICON-BASED PART WITH AT LEAST ONE OPTICAL ILLUSION PATTERN

(30) Priorité: 11.11.2015 EP 15194156
(43) Date de publication de la demande: 17.05.2017
(73) Titulaire: Nivarox-FAR S.A., 2400 Le Locle (CH)
(72) Inventeur: Cusin, Pierre, 1423 Villars-Burquin (CH); Gandelhman, Alex, 2000 Neuchâtel (CH); Musy, Michel, 2552 Orpund (CH)
(74) Mandataire: Goulette, Ludivine

(56) Documents cités:
- EP-A1- 1 722 281
- EP-A2- 2 784 600
- US-A- 4 725 511
- US-B1- 8 314 989

## Description

### Domaine de l'invention

L'invention se rapporte à un procédé de fabrication d'une pièce à base de silicium dont une face plane comporte au moins un motif à illusion d'optique et, plus précisément, au moins un motif faisant croire que la face plane ne l'est pas et/ou comporte deux types de matériau.

### Arrière-plan de l'invention

Il est connu de former des pièces d'habillage dont la surface supérieure est facettée et/ou chanfreinée afin d'améliorer l'esthétique d'une pièce d'horlogerie. Le document EP 1 722 281 A1 divulgue un procédé de fabrication d'une pièce à base de silicium avec au moins un motif à illusion d'optique comportant les étapes suivantes : gravure d'au moins un trou traversant l'épaisseur d'une couche à base de silicium pour former le contour de ladite au moins une pièce et des évidements borgnes dans l'épaisseur de la couche à base de silicium afin de former ladite au moins une pièce avec une face plane comportant ledit au moins un motif à illusion d'optique ; libération de ladite pièce ainsi formée du substrat, ladite étape de gravure comportant une phase de formation d'au moins un masque avec une ouverture sur la couche à base de silicium pour former ledit au moins un trou traversant, ainsi qu'une phase de gravure à l'aide d'au moins une attaque anisotrope de cette couche à base de silicium.

### Résumé de l'invention

Le but de la présente invention est de pallier tout ou partie les inconvénients cités précédemment en proposant un procédé de fabrication ne nécessitant ni facettage ni retouche pour obtenir une pièce plus simple à base de silicium offrant l'illusion d'un facettage et/ou d'un chanfreinage et/ou d'une pièce composite.

A cet effet, l'invention se rapporte à un procédé de fabrication d'au moins une pièce à base de silicium avec au moins un motif à illusion d'optique caractérisé en ce qu'il comporte les étapes suivantes :
a) formation d'un substrat comportant une couche à base de silicium;
b) gravure d'au moins un trou traversant l'épaisseur de la couche à base de silicium pour former en une même attaque le contour de ladite au moins une pièce et des évidements borgnes dans l'épaisseur de la couche à base de silicium afin de former ladite au moins une pièce avec une face plane comportant ledit au moins un motif à illusion d'optique permettant de faire croire que ladite face n'est pas plane en étant un motif à illusion d'optique de type illusion d'un facettage et/ou d'un chanfreinage et/ou d'une pièce composite ;
c) libération de ladite au moins une pièce ainsi formée du substrat,
ladite étape de gravure comportant une phase de formation d'au moins un masque avec des ouvertures sur la couche à base de silicium, l'ouverture utilisée pour former ledit au moins un trou traversant étant plus large que celles utilisées pour former les évidements borgnes, ainsi qu'une phase de gravure à l'aide d'au moins une attaque anisotrope de cette couche à base de silicium.

On comprend donc que le procédé de fabrication permet, grâce à la planéité de la couche à base de silicium, d'obtenir une pièce dont une face plane n'a plus besoin d'être *a posteriori* facettée ou, plus globalement, *a posteriori* retouchée.

De plus, le procédé de fabrication offre une très grande précision des cotes et une très grande reproductibilité d'un même type de pièces monoblocs à base de silicium, ou de plusieurs pièces monoblocs différentes à base de silicium, sur un même substrat.

Enfin, la très grande précision et la très grande reproductibilité du procédé de fabrication permettent, avantageusement selon l'invention, d'obtenir une pièce très simple munie d'au moins un motif très fin et facilement reproductible faisant croire qu'une face plane ne l'est pas à la manière d'un usinage comme un biseautage ou un chanfreinage.

Conformément à d'autres variantes avantageuses de l'invention :
- selon un premier mode de réalisation, les évidements borgnes forment au moins deux séries de segments parallèles, la première série de segments parallèles joignant la deuxième série de segments parallèles selon un angle compris entre 10 et 170 degrés afin d'offrir à ladite au moins une pièce l'illusion que ladite face plane comporte deux faces biseautées formant une arête ;
- selon un deuxième mode de réalisation, les évidements borgnes forment au moins une série de segments courbes afin d'offrir à ladite au moins une pièce l'illusion que ladite face plane est bombée ;
- selon un troisième mode de réalisation, les évidements borgnes forment au moins une série d'évidements distribués symétriquement les uns par rapport aux autres, ladite au moins une série d'évidements étant formée adjacente à une partie dont la surface de ladite au moins une pièce ne comporte aucun évidement afin d'offrir à ladite au moins une pièce l'illusion que ladite face plane comporte deux faces biseautée formant une arête ;
- selon un quatrième mode de réalisation, les évidements borgnes sont distribuée à la périphérie de ladite au moins une pièce et forment au moins deux séries de segments parallèles, les segments parallèles de la première série étant perpendiculaires aux segments et se joignant selon un angle permettant d'offrir à ladite au moins une pièce l'illusion que ladite face plane est chanfreinée ;
- selon un cinquième mode de réalisation, les évidements borgnes forment au moins une série d'évidements distribués symétriquement les uns par rapport aux autres, ladite au moins une série d'évidements étant bordée par des surfaces de ladite au moins une pièce ne comportant aucun évidement afin d'offrir à ladite pièce l'illusion que ladite face plane est formée en relief avec deux matériaux différents;
- les évidements borgnes ont une profondeur comprise entre 2 et 100 *µ*m ;
- le procédé comporte en outre, entre l'étape b) et l'étape c), l'étape d) : former au moins un trou traversant dans l'épaisseur du reste du substrat afin de former ladite au moins une pièce avec un moyen de fixation ;
- la couche à base de silicium comporte une épaisseur comprise entre 50 et 500 *µ*m ;
- selon une première alternative, l'étape b) comporte les phases e) : former un masque avec des ouvertures sur la couche à base de silicium, l'ouverture utilisée pour former ledit au moins un trou traversant étant plus large que celles utilisées pour former les évidements borgnes, f) : graver à l'aide d'une attaque anisotrope la couche à base de silicium selon les ouvertures du masque et g) : retirer le masque ;
- la pièce à base de silicium comporte du silicium monocristallin, du silicium monocristallin dopé, du silicium amorphe, du silicium poreux, du silicium polycristallin, du nitrure de silicium, du carbure de silicium, du quartz ou de l'oxyde de silicium ;
- plusieurs pièces sont formées dans la même couche à base de silicium ;
- ladite au moins une pièce forme tout ou partie d'un cadran, d'un décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

### Description sommaire des dessins

D'autres particularités et avantages ressortiront clairement de la description qui en est faite ci-après, à titre indicatif et nullement limitatif, en référence aux dessins annexés, dans lesquels :
- les figures 1 à 5 sont des représentations d'étapes de procédés selon l'invention ;
- les figures 6 à 11 représentent des exemples d'aiguilles obtenues selon l'invention ;
- les figures 12 à 18 représentent des exemples d'heures index obtenus selon l'invention ;
- la figure 19 représente un exemple de décoration de guichet obtenu selon l'invention.

### Description détaillée des modes de réalisation préférés

La présente invention se rapporte à un procédé de fabrication d'une pièce monobloc de forme simple à base de silicium offrant l'illusion d'un facettage et/ou d'un chanfreinage pour former tout ou partie de l'habillage d'une pièce d'horlogerie. A titre d'exemple nullement limitatif, la pièce peut ainsi former tout ou partie d'un cadran, d'une décoration de guichet, d'un réhaut, d'une lunette, d'un poussoir, d'une couronne, d'un fond de boîtier, d'une masse oscillante, d'une aiguille, d'un bracelet, d'un maillon, d'un fermoir, d'un décor ou d'une applique.

Bien entendu, une telle pièce ne saurait se limiter au domaine de l'horlogerie. A titre d'exemple nullement limitatif, une telle pièce pourrait alternativement former tout ou partie d'un article de bijouterie ou de joaillerie.

Le procédé est destiné à fabriquer au moins une pièce à base de silicium. Le terme « à base de silicium » signifie que le silicium seul ou sous forme d'un composé peut entrer dans la composition de la pièce. Ainsi, à titre d'exemple nullement limitatif, la (ou les) pièce(s) peut par exemple être formée avec du silicium monocristallin quelle que soit son orientation cristalline, du silicium monocristallin dopé quelle que soit son orientation cristalline, du silicium amorphe, du silicium poreux, du silicium polycristallin, du nitrure de silicium, du carbure de silicium, du quartz quelle que soit son orientation cristalline ou de l'oxyde de silicium.

Avantageusement selon l'invention, chaque pièce à base de silicium obtenue par le procédé comporte au moins un motif à illusion d'optique. Plus précisément, chaque pièce comporte, de manière avantageuse, une face sensiblement plane avec au moins un motif à illusion d'optique faisant croire que ladite surface sensiblement plane ne l'est pas plane ce qui permet d'avoir une pièce simple offrant, par exemple, l'illusion d'un facettage et/ou d'un chanfreinage et/ou d'une pièce composite.

Par soucis de simplification, les figures présentées montrent la fabrication d'une seule pièce sur un substrat. Toutefois, avantageusement selon l'invention, le procédé autorise plusieurs pièces identiques ou différentes à être formées sur le même substrat.

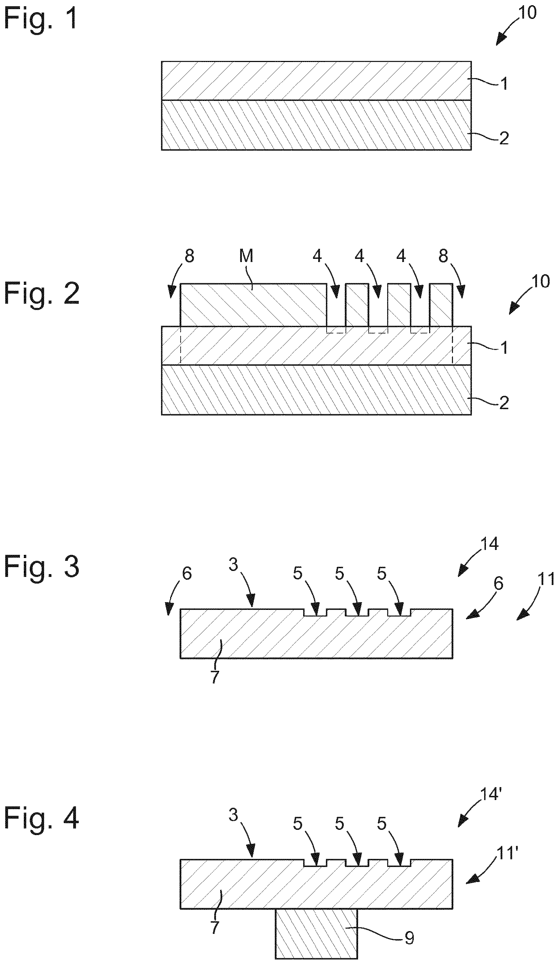

Comme visible à la figure 1, le procédé selon l'invention comporte une première étape a) destinée à former un substrat 10 comportant une couche 1 à base de silicium dont l'épaisseur est comprise entre 50 et 500 *µ*m. Dans l'exemple illustré à la figure 1, on remarque que le substrat 10 comporte en outre une couche 2 de support destinée à recevoir la couche 1 à base de silicium. Suivant les variantes expliquées ci-dessous, la couche 2 de support peut être choisie quant au matériau utilisé ou être de nature totalement indifférente.

Comme illustré à la figure 2, le procédé se poursuit avec une deuxième étape b) destinée à graver au moins un trou 6 traversant l'épaisseur de la couche 1 à base de silicium pour former le corps 7 de la pièce 11. Cela signifie que, suivant la pièce 11 à former, un ou plusieurs trous 6 traversants peuvent être réalisés. La deuxième étape b) est également destinée à graver des évidements 5 borgnes dans l'épaisseur de la couche 1 à base de silicium afin de former ladite au moins une pièce 11 avec une face plane comportant ledit au moins un motif 14 à illusion d'optique permettant de faire croire que ladite face n'est pas plane.

La forme générale dudit au moins un motif à illusion d'optique 14 sera mieux expliquée ci-dessous. Pour des raisons d'intelligibilité, les évidements 5 borgnes sont représentés schématiquement à la figure 2 en pointillés par trois creux dans la surface supérieure 3 de la couche 1 à base de silicium.

De plus, les évidements 5 borgnes pratiqués dans la couche 1 peuvent s'étendre selon une profondeur comprise entre 2 et 100 *µ*m à partir de la surface supérieure 3 de la couche 1 à base de silicium.

Comme illustré à la figure 2, l'étape b) comporte, selon une première alternative préférée, trois phases e) à g). L'étape b) comporte une première phase e) destinée à former un masque M avec des ouvertures 4, 8 sur la couche 1 à base de silicium. Selon l'invention, l'ouverture 8 utilisée pour former ledit au moins un trou 6 traversant est plus large que celles 4 utilisées pour former les évidements 5 borgnes. Une telle phase e) peut, par exemple, être obtenue par photolithographie d'une résine photosensible, par structuration d'une couche (comme de l'oxyde de silicium) ou par dépôt sélectif d'une couche de métal ou de nitrure de silicium. Bien entendu, d'autres procédés de formation et/ou d'autres matériaux du masque sont possibles.

Le procédé se poursuit avec une deuxième phase f) destinée à graver, à l'aide d'une attaque anisotrope, la couche 1 à base de silicium selon les ouvertures 4, 8 du masque M. On comprend donc que l'attaque anisotrope, comme par exemple un gravage ionique réactif profond, enlèvera plus profondément le matériau à base de silicium dans ladite au moins une ouverture 8 plus larges que dans les ouvertures 4. Cette différence de vitesse de gravage permet avantageusement de former en une même attaque ledit au moins un trou 6 traversant et des évidements 5 borgnes dans la couche 1 à base de silicium.

Enfin, l'étape b) se termine avec une troisième phase g) destinée à retirer le masque M. Cette troisième phase g) est généralement obtenue par une attaque chimique sélective du matériau utilisé pour le masque M.

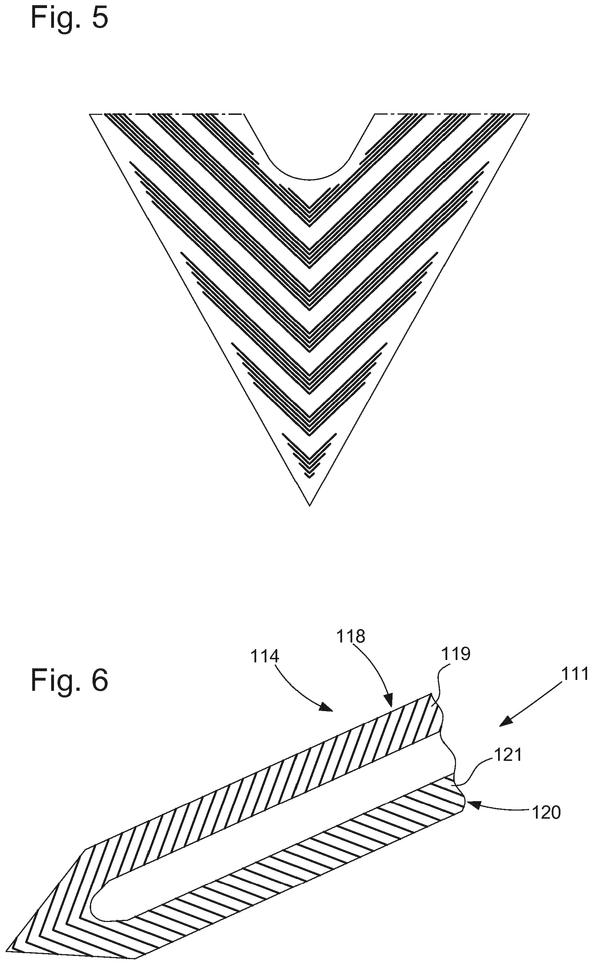

Selon une variante qui ne fait pas partie de la présente invention, les ouvertures 4 correspondant à la forme des futurs évidements 5 borgnes sont divisées en des ouvertures plusieurs fois plus petites comme illustré à la figure 5. A titre d'exemple, les ouvertures plusieurs fois plus petites pourraient comporter une largeur comprise entre 2 et 3 *µ*m intercalée par une largeur sans ouverture comprise entre 3 et 5 *µ*m.

Puis après la phase g), l'étape b) comporte une phase d'oxydation de la couche 1 à base de silicium destinée à oxyder totalement les parois les plus minces illustrées à la figure 5 qui sont formées uniquement au niveau des futurs évidements 5 borgnes souhaités. Enfin, l'étape b) se termine par la désoxydation de la couche 1 à base de silicium destinée à former les évidements 5 borgnes. Cette variante est particulièrement utile quand les évidements 5 borgnes sont voulus bien moins profonds que ledit au moins un trou 6 traversant.

Selon une alternative qui ne fait pas partie de la présente invention, l'étape b) comporte, les six phases h) à m). L'étape b) comporte ainsi une première phase h) destinée à former un premier masque avec des ouvertures 4, 8 selon les formes dudit au moins un trou 6 traversant et des évidements 5 borgnes. L'alternative se poursuit avec une deuxième phase i) destinée à former un deuxième masque sur le premier masque avec ladite au moins une ouverture 8 uniquement selon la formes dudit au moins un trou 6 traversant. On comprend donc que les ouvertures 4 du premier masque sont cachées par le deuxième masque.

L'alternative comporte ensuite une troisième phase j) destinée à graver partiellement, c'est-à-dire selon une partie de l'épaisseur uniquement, à l'aide d'une première attaque anisotrope, la couche 1 à base de silicium selon ladite au moins une ouverture 8 des premier et deuxième masques. Dans une quatrième phase k), le deuxième masque est retiré puis une cinquième phase l) est destinée à graver, à l'aide d'une deuxième attaque anisotrope, la couche 1 à base de silicium selon les ouvertures 4, 8 du premier masque de manière à obtenir ledit au moins un trou 6 traversant et les évidements 5 borgnes. Enfin, l'alternative se termine avec la phase m) destinée à retirer le premier masque. Même sans être représentée, on comprend que cette deuxième alternative permet d'obtenir le même résultat sans être limité par une quelconque différence de largeurs à respecter entre les ouvertures 4 et 8.

Selon une autre alternative non représentée, l'étape b) comporte des phases successives de gravage dudit au moins un trou 6 traversant et des évidements 5 borgnes, c'est-à-dire, soit d'abord le gravage dudit au moins un trou 6 traversant puis des évidements 5 borgnes, soit l'inverse. A titre d'exemple, l'étape b) selon l'autre alternative pourrait ainsi comporter deux processus comprenant des phases similaires aux phases e) à g), chaque processus étant destiné à graver ledit au moins un trou 6 traversant ou les évidements 5 borgnes. Par conséquent, on comprend que cette alternative permet également d'obtenir le même résultat.

Avantageusement selon l'invention, le procédé permet, grâce à la précision de la photolithographie utilisée lors de l'étape b), d'obtenir un corps 7 à base de silicium avec des cotes externes et, éventuellement, internes d'une grande précision propre à respecter les tolérances très élevées d'une pièce dans le domaine de l'horlogerie. Par cotes internes, il faut comprendre que ledit au moins un trou 6 traversant pourrait, en plus, de détourer le corps 7, également former un trou dans le corps 7 détouré lors de l'étape b), pour y recevoir, par exemple, ultérieurement un organe. On comprend alors qu'il y aurait plusieurs trous 6 traversants qui seraient formés en plus des évidements 5 borgnes.

Enfin, le procédé se termine avec une troisième et dernière étape c) destinée à libérer la pièce 11 ainsi formée du substrat 10. Par conséquent, l'étape c) peut consister en une attaque sélective de la couche 2 de support.

Selon une autre variante du procédé illustrée à la figure 4, le procédé peut comporter en outre, entre l'étape b) et l'étape c), l'étape optionnelle d) destinée à former des trous traversants dans l'épaisseur du reste du substrat 10 afin de former une pièce 11' avec un moyen 9 de fixation.

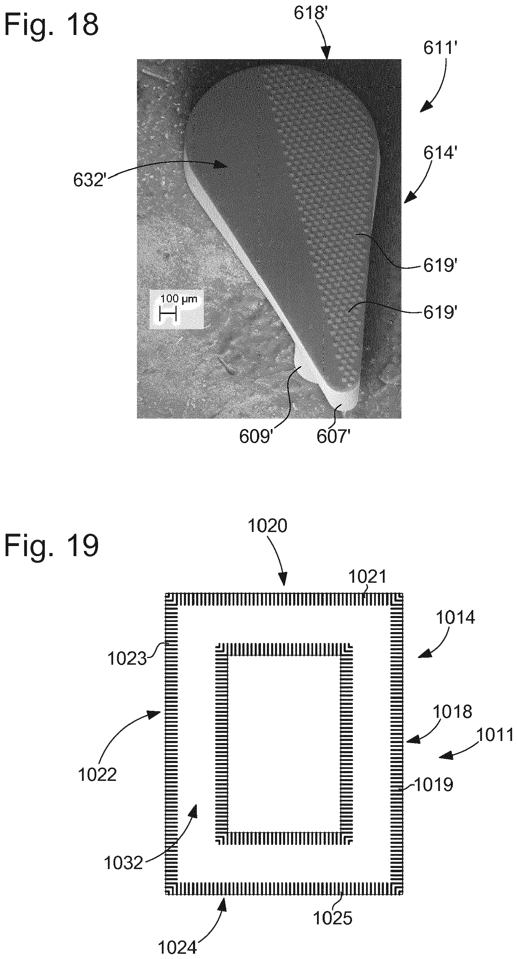

Du fait du positionnement précis de chaque corps 7 sur le substrat 10, il est possible, lors de l'étape d), de graver la couche 2 du substrat 10 selon des cotes précises. Dans cette variante, la couche 2 de support est préférentiellement à base de silicium afin d'utiliser les mêmes types de gravage que pour l'étape b) décrite ci-dessus. Une telle étape d) permet avantageusement selon l'invention d'obtenir une pièce 611' comme décrite ci-dessous en relation avec la figure 18.

On comprend alors, qu'en plus de la face 3 plane et des évidements 5 formant ledit au moins un motif 14', 614' à illusion d'optique, la pièce 11', 611' comporte en outre au moins un moyen 9, 609' de fixation destiné à attacher la pièce 11', 611'. Le moyen 9, 609' de fixation peut ainsi prendre la forme d'un pied ou d'un canon.

Les figures 6 à 19 représentent des exemples de pièces obtenues selon le procédé permettant de mieux expliquer un motif à illusion d'optique selon l'invention. A titre nullement limitatif, il est expliqué quatre modes de réalisation de motif à illusion d'optique.

Selon un premier mode de réalisation, le motif 114, 214, 514 et 714 à illusion d'optique des figures 6, 7, 12 et 16 forme ainsi au moins deux séries 118, 120, 218, 220, 518, 520, 718, 720 de segments 119, 121, 219, 221, 519, 521, 719, 721 parallèles. Préférentiellement selon le premier mode de réalisation, la première série 118, 218, 518, 718 de segments 119, 219, 519, 719 parallèles joignant la deuxième série 120, 220, 520, 720 de segments 121, 221, 521, 721 parallèles selon un angle compris entre 10 et 170 degrés afin d'offrir à la pièce 111, 211, 511, 711 l'illusion d'une face visible avec deux faces biseautées formant une arête alors qu'elle est plane. A titre d'exemple, le motif 114, 214, 514 et 714 à illusion d'optique des figures 6, 7, 12 et 16 pourrait comporter des ouvertures d'une largeur comprise entre 35 et 45 *µ*m intercalés par une largeur sans ouverture comprise entre 30 et 35 *µ*m.

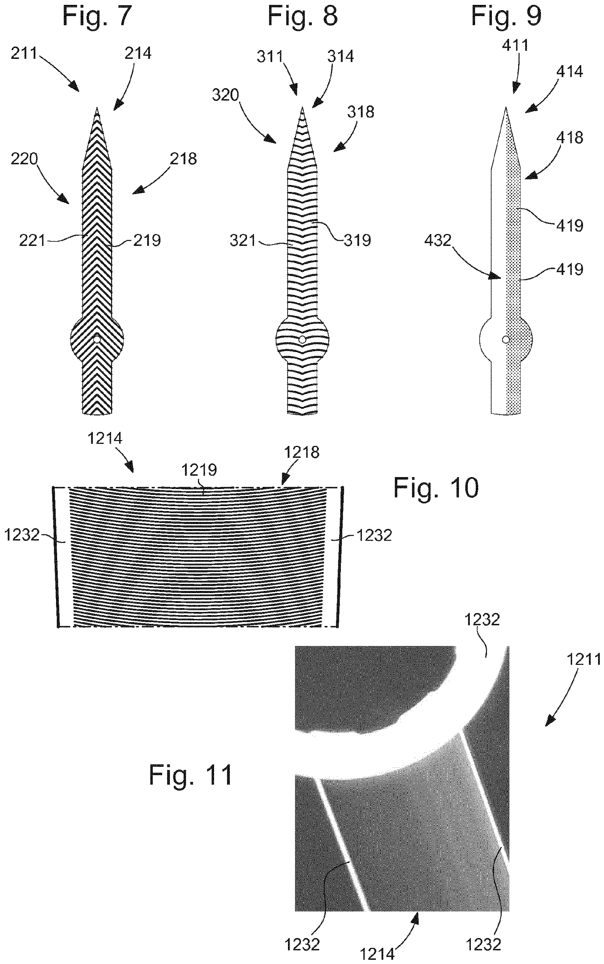

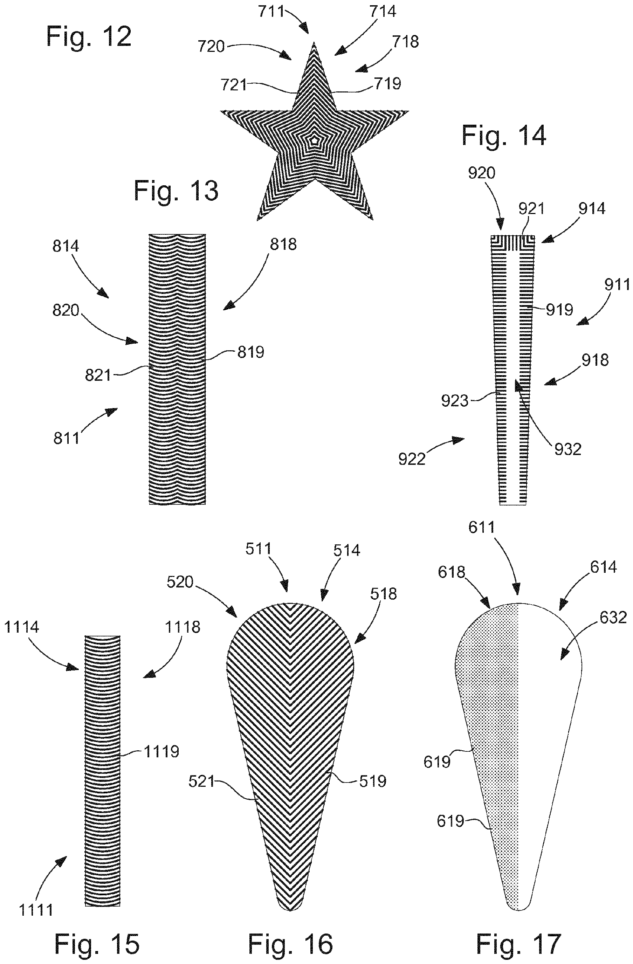

Selon un deuxième mode de réalisation, le motif 314, 814 et 1114 à illusion d'optique des figures 8, 13 et 15 forme ainsi au moins une série 318, 320, 818, 820, 1118 de segments 319, 321, 819, 821, 1119 courbes afin d'offrir à la pièce 311, 811, 1111 l'illusion que la face visible est bombée alors qu'elle est plane. Selon une variante du deuxième mode de réalisation visible aux figures 8 et 13, une première série 318, 818 de segments 319, 819 courbes joint une deuxième série 320, 820 de segments 321, 821 courbes selon un angle compris entre 10 et 170 degrés afin d'offrir à la pièce 311, 811 l'illusion que la face visible comporte deux faces bombées formant une rainure alors que la face est plane. A titre d'exemple, le motif 314, 814 et 1114 à illusion d'optique des figures 8, 13 et 15 pourrait comporter des ouvertures d'une largeur comprise entre 35 et 45 *µ*m intercalés par une largeur sans ouverture comprise entre 30 et 35 *µ*m.

Selon un troisième mode de réalisation, le motif 414 et 614 à illusion d'optique des figures 9 et 17 forme ainsi au moins une série 418, 618 d'évidements 419, 619 distribués symétriquement les uns par rapport aux autres. Préférentiellement selon le troisième mode de réalisation, ladite au moins une série 418, 618 d'évidements étant formée adjacente à une partie 432, 632 dont la surface de la pièce 411, 611 ne comporte aucun motif à illusion d'optique afin d'offrir à la pièce 411, 611 l'illusion que la face visible comporte deux faces biseautée formant une arête alors qu'elle est plane. A titre d'exemple, le motif 414 et 614 à illusion d'optique des figures 9 et 17 pourrait comporter des évidements 419, 619 couvrant entre 40% et 60% de la surface dudit motif 414, 619.

Comme visible aux figures 9 et 17, les évidements 419, 619 sont de section circulaire et régulièrement espacés entre eux. Bien entendu, la géométrie et la distribution des évidements 419, 619 peuvent différer suivant l'effet souhaité sans sortir du cadre de l'invention.

Selon un quatrième mode de réalisation, le motif 914 et 1014 à illusion d'optique des figures 14 et 19 est distribué à la périphérie de la pièce 911, 1011 et forme ainsi au moins deux séries 918, 920, 922, 1018, 1020, 1022, 1024 de segments 919, 921, 923, 1019, 1021, 1023, 1025 parallèles, les segments 919, 923, 1019, 1023 parallèles de la première série 918, 922, 1018, 1022 étant perpendiculaires aux segments 921, 1021, 1025 parallèles de la deuxième série 920, 1020, 1024 et se joignant selon un angle à 90 degrés afin d'offrir à la pièce 911, 1011 l'illusion que la face visible est chanfreinée et entoure une partie 932, 1032 dont la surface de la pièce 911, 1011 ne comporte aucun motif à illusion d'optique alors qu'elle est plane. A titre d'exemple, le motif 914 et 1014 à illusion d'optique des figures 14 et 19 pourrait comporter des ouvertures d'une largeur comprise entre 35 et 45 *µ*m intercalés par une largeur sans ouverture comprise entre 30 et 35 *µ*m.

L'angle de 90 degrés est préférentiellement choisi car les faces externes des pièces 911, 1011 font un angle comparable à chaque coin. On comprend que cet angle de 90 degrés peut être plus grand ou plus petit suivant l'angle de chaque coin pour continuer à offrir l'illusion d'une face visible chanfreinée.

Selon un cinquième mode de réalisation illustré aux figures 10 et 11, le motif 1214 à illusion d'optique forme au moins une série 1218 d'évidements 1219 distribués symétriquement les uns par rapport aux autres comme mieux visible à la figure 10. Ladite au moins une série 1218 d'évidements étant bordée par des surfaces 1232 de la pièce 1211 ne comportant aucun évidement afin d'offrir à la pièce 1211 l'illusion, comme illustré à la figure 11, que la face visible est sombre et bordée par un autre matériau plus claire alors que la face est plane et que la pièce 1211 ne comporte qu'un seul matériau à base de silicium. On comprend en fait que le motif 1214 à illusion d'optique se comporte comme un piège de lumière qui limite la réflexion contrairement aux surfaces 1232. A titre d'exemple, le motif 1214 à illusion d'optique des figures 17 et 18 pourrait comporter des ouvertures d'une largeur comprise entre 2 et 3 *µ*m intercalés par une largeur sans ouverture comprise entre 5 et 9 *µ*m.

Selon une variante du cinquième mode de réalisation, la pièce 1211 est en plus recouverte d'une couche de réflexion, comme, par exemple, à base de chrome, afin d'améliorer encore le contraste entre la zone sombre formée par le motif 1214 à illusion d'optique et la (ou les) surface(s) 1232 sans motif.

Bien entendu, la présente invention ne se limite pas à l'exemple illustré mais est susceptible de diverses variantes et modifications qui apparaîtront à l'homme de l'art. En particulier, les motifs 14, 114, 214, 314, 414, 514, 614, 714, 814, 914, 1014, 1114 à illusion d'optique ne sauraient se limiter à ceux décrits ci-dessus. Ainsi, d'autres modes de réalisation sont possibles sans sortir du cadre de l'invention.

Ainsi, dans une alternative particulière du troisième mode de réalisation illustrée à la figure 18, le motif 614' à illusion d'optique forme au moins une série 618' d'évidements 619' distribués symétriquement les uns par rapport aux autres. Comme visible à la figure 18, ladite au moins une série 618' d'évidements est formée adjacente à une partie 632' dont la surface de la pièce 611' ne comporte aucun motif à illusion d'optique afin d'offrir à ladite pièce l'illusion que la face visible comporte deux faces biseautée formant une arête alors qu'elle est plane.

Les évidements 619' sont de volume pyramidal tronqué à base carrée et régulièrement espacés entre eux. Cette alternative particulière est obtenue avec une couche 1 en silicium monocristallin orientée selon le plan (100). De plus, l'étape b) utilise un gravage humide à l'hydroxyde de potassium (KOH) permettant de former des gravures dont les flancs sont obliques et non verticaux comme illustré aux figures 1 à 3. En effet, même avec un masque de gravage offrant des ouvertures discoïdales, le gravage humide suit les mailles de la structure cristallographique de la couche 1 en silicium monocristallin orientée selon le plan (100) en donnant une gravure pyramidale à base carrée.

De plus, comme visible à la figure 18, le substrat 10 étant du type silicium sur isolant (abréviation anglaise « S.O.I. »), la couche 2 également en silicium monocristallin est également gravée, par exemple par une attaque sèche ou humide, afin d'obtenir plusieurs pieds 609' destinés à fixer la pièce 611'.

Enfin, les cinq modes de réalisation présentés ci-dessus sont susceptibles d'être combinés entre eux, c'est-à-dire que plusieurs motifs différents peuvent apparaître sur la même pièce.

## Revendications

1. Procédé de fabrication d'au moins une pièce (11, 111, 211, 311, 411, 511, 611, 611', 711, 811, 911, 1011, 1111, 1211) à base de silicium avec au moins un motif (14, 114, 214, 314, 414, 514, 614, 614', 714, 814, 914, 1014, 1114, 1214) à illusion d'optique comportant les étapes suivantes :
a) formation d'un substrat (10) comportant une couche (1) à base de silicium ;
b) gravure d'au moins un trou (6) traversant l'épaisseur de la couche (1) à base de silicium pour former en une même attaque le contour de ladite au moins une pièce (11, 111, 211, 311, 411, 511, 611, 611', 711, 811, 911, 1011, 1111, 1211) et des évidements (5) borgnes dans l'épaisseur de la couche (1) à base de silicium afin de former ladite au moins une pièce (11, 111, 211, 311, 411, 511, 611, 611', 711, 811, 911, 1011, 1111, 1211) avec une face plane comportant ledit au moins un motif (14, 114, 214, 314, 414, 514, 614, 614', 714, 814, 914, 1014, 1114, 1214) à illusion d'optique permettant de faire croire que ladite face n'est pas plane en étant un motif à illusion d'optique de type illusion d'un facettage et/ou d'un chanfreinage et/ou d'une pièce composite ;
c) libération de ladite au moins une pièce (11, 111, 211, 311, 411, 511, 611, 611', 711, 811, 911, 1011, 1111, 1211) ainsi formée du substrat (10),
ladite étape de gravure comportant une phase de formation d'au moins un masque avec des ouvertures (4, 8) sur la couche (1) à base de silicium, l'ouverture (8) utilisée pour former ledit au moins un trou (6) traversant étant plus large que celles (4) utilisées pour former les évidements (5) borgnes, ainsi qu'une phase de gravure à l'aide d'au moins une attaque anisotrope de cette couche à base de silicium.

2. Procédé selon la revendication précédente, **caractérisé en ce que** les évidements (5) borgnes forment au moins deux séries de segments parallèles, la première série (118, 218, 518, 718) de segments (119, 219, 519, 719) parallèles joignant la deuxième série (120, 220, 520, 720) de segments (121, 221, 521, 721) parallèles selon un angle compris entre 10 et 170 degrés afin d'offrir à ladite au moins une pièce l'illusion que ladite face plane comporte deux faces biseautées formant une arête.

3. Procédé selon la revendication 1, **caractérisé en ce que** les évidements (5) borgnes forment au moins une série (318, 320, 818, 820, 1118) de segments (319, 321, 819, 821, 1119) courbes afin d'offrir à ladite au moins une pièce l'illusion que ladite face plane est bombée.

4. Procédé selon la revendication 1, **caractérisé en ce que** les évidements (5) borgnes forment au moins une série (418, 618) d'évidements (419, 619) distribués symétriquement les uns par rapport aux autres, ladite au moins une série d'évidements étant formée adjacente à une partie (432, 632) dont la surface de la pièce (11, 111, 211, 311, 411, 511, 611, 611', 711, 811, 911, 1011, 1111, 1211) ne comporte aucun évidement afin d'offrir à ladite au moins une pièce l'illusion que ladite face plane comporte deux faces biseautée formant une arête.

5. Procédé selon la revendication 1, **caractérisé en ce que** les évidements (5) borgnes sont distribuée à la périphérie de ladite au moins une pièce (11, 111, 211, 311, 411, 511, 611, 611', 711, 811, 911, 1011, 1111, 1211) et forment au moins deux séries de segments parallèles, les segments (919, 923, 1019, 1023) parallèles de la première série (918, 922, 1018, 1022) étant perpendiculaires aux segments (921, 1021, 1025) parallèles de la deuxième série (920, 1020, 1024) et se joignant selon un angle permettant d'offrir à ladite au moins une pièce l'illusion que ladite face plane est chanfreinée.

6. Procédé selon la revendication 1, **caractérisé en ce que** les évidements (5) borgnes forment au moins une série (1218) d'évidements (1219) distribués symétriquement les uns par rapport aux autres, ladite au moins une série d'évidements étant bordée par des surfaces (1232) de ladite au moins une pièce (11, 111, 211, 311, 411, 511, 611, 611', 711, 811, 911, 1011, 1111, 1211) ne comportant aucun évidement afin d'offrir à ladite au moins une pièce l'illusion que ladite face plane est formée en relief avec deux matériaux différents.

7. Procédé selon l'une des revendications précédentes, **caractérisé en ce que** les évidements (5) borgnes ont une profondeur comprise entre 2 et 100 *µ*m.

8. Procédé selon l'une des revendications précédentes, **caractérisé en ce que** le procédé comporte en outre, entre l'étape b) et l'étape c), l'étape suivante :
d) former au moins un trou traversant dans l'épaisseur du reste du substrat afin de former ladite au moins une pièce (11, 111, 211, 311, 411, 511, 611, 611', 711, 811, 911, 1011, 1111, 1211) avec un moyen de fixation (9, 609').

9. Procédé selon l'une des revendications précédentes, **caractérisé en ce que** la couche (1) à base de silicium comporte une épaisseur comprise entre 50 et 500 *µ*m.

10. Procédé selon l'une des revendications précédentes, **caractérisé en ce que** l'étape b) comporte les phases suivantes :
e) former un masque (M) avec des ouvertures (4, 8) sur la couche (1) à base de silicium, l'ouverture (8) utilisée pour former ledit au moins un trou (6) traversant étant plus large que celles (4) utilisées pour former les évidements (5) borgnes ;
f) graver à l'aide d'une attaque anisotrope la couche à base de silicium selon les ouvertures (4, 8) du masque (M) ;
g) retirer le masque (M).

11. Procédé selon l'une des revendications précédentes, **caractérisé en ce que** la pièce (11, 111, 211, 311, 411, 511, 611, 611', 711, 811, 911, 1011, 1111, 1211) à base de silicium comporte du silicium monocristallin, du silicium monocristallin dopé, du silicium amorphe, du silicium poreux, du silicium polycristallin, du nitrure de silicium, du carbure de silicium, du quartz ou de l'oxyde de silicium.

12. Procédé selon l'une des revendications précédentes, **caractérisé en ce que** plusieurs pièces (11, 111, 211, 311, 411, 511, 611, 611', 711, 811, 911, 1011, 1111, 1211) sont formées dans la même couche (1) à base de silicium.

13. Procédé selon l'une des revendications précédentes, **caractérisé en ce que** ladite au moins une pièce (11, 111, 211, 311, 411, 511, 611, 611', 711, 811, 911, 1011, 1111, 1211) forme tout ou partie d'un cadran, d'un décoration de guichet, d'un réhaut, d'une lunette, d'un poussoir, d'une couronne, d'un fond de boîtier, d'une aiguille, d'un bracelet, d'un maillon, d'un fermoir, d'un décor, d'une masse oscillante ou d'une applique.

## Patentansprüche

1. Herstellungsverfahren für mindestens ein Werkstück (11, 111, 211, 311, 411, 511, 611, 611', 711, 811, 911, 1011, 1111, 1211) auf Siliciumbasis mit mindestens einem Motiv (14, 114, 214, 314, 414, 514, 614, 614', 714, 814, 914, 1014, 1114, 1214) mit optischer Täuschung, umfassend die folgenden Schritte:
a) Bilden eines Substrats (10) mit einer Schicht (1) auf Siliciumbasis;
b) Gravieren mindestens eines Lochs (6) durch die Dicke der Schicht (1) auf Siliciumbasis, um in einem einzelnen Einfressungsprozess die Kontur des mindestens einen Werkstücks (11, 111, 211, 311, 411, 511, 611, 611', 711, 811, 911, 1011, 1111, 1211) und Blindaussparungen (5) in der Dicke der Schicht (1) auf Siliciumbasis zu bilden, um das mindestens eine Werkstück (11, 111, 211, 311, 411, 511, 611, 611', 711, 811, 911, 1011, 1111, 1211) mit einer ebenen Fläche zu bilden, die das mindestens eine Motiv (14, 114, 214, 314, 414, 514, 614, 614', 714, 814, 914, 1014, 1114, 1214) mit optischer Täuschung aufweist, was ermöglicht, den Eindruck zu erwecken, dass die Fläche nicht eben ist, indem sie ein Motiv mit optischer Täuschung nach Art einer Vortäuschung einer Facettierung und/oder einer Abschrägung und/oder eines Verbundteils darstellt;
c) Freigeben des somit aus dem Substrat (10) gebildeten Werkstücks (11, 111, 211, 311, 411, 511, 611, 611', 711, 811, 911, 1011, 1111, 1211),wobei der Gravierschritt eine Phase des Bildens mindestens einer Maske mit Öffnungen (4, 8) in der Schicht (1) auf Siliciumbasis umfasst, wobei die Öffnung (8), die zum Bilden des mindestens einen Durchgangslochs (6) verwendet wird, größer ist als jene (4), die zum Ausbilden der Blindaussparungen (5) verwendet werden, und eine Phase des Gravierens mit Hilfe mindestens einer anisotropen Einfressung dieser Schicht auf Siliciumbasis umfasst.

2. Verfahren nach dem vorhergehenden Anspruch, **dadurch gekennzeichnet, dass** die Blindaussparungen (5) mindestens zwei Reihen paralleler Segmente bilden, wobei die erste Reihe (118, 218, 518, 718) paralleler Segmente (119, 219, 519, 719) mit der zweiten Reihe (120, 220, 520, 720) paralleler Segmente (121, 221, 521, 721) unter einem Winkel im Bereich von 10 bis 170 Grad verbunden ist, um dem mindestens einen Werkstück die Täuschung zu verleihen, dass die ebene Fläche zwei abgeschrägte Flächen aufweist, die eine Kante bilden.

3. Verfahren nach Anspruch 1, **dadurch gekennzeichnet, dass** die Blindaussparungen (5) mindestens eine Reihe (318, 320, 818, 820, 1118) gekrümmter Segmente (319, 321, 819, 821, 1119) bilden, um dem mindestens einen Werkstück die Täuschung zu verleihen, dass die ebene Fläche gewölbt ist.

4. Verfahren nach Anspruch 1, **dadurch gekennzeichnet, dass** die Blindaussparungen (5) mindestens eine Reihe (418, 618) von relativ zueinander symmetrisch verteilten Aussparungen (419, 619) bilden, wobei die mindestens eine Reihe von Aussparungen benachbart zu einem Teil (432, 632) gebildet ist, bei dem die Oberfläche des Werkstücks (11, 111, 211, 311, 411, 511, 611, 611', 711, 811, 911, 1011, 1111, 1211) keinerlei Aussparung aufweist, um dem mindestens einen Werkstück die Täuschung zu verleihen, dass die ebene Fläche zwei abgeschrägte Flächen aufweist, die eine Kante bilden.

5. Verfahren nach Anspruch 1, **dadurch gekennzeichnet, dass** die Blindaussparungen (5) am Umfang des mindestens einen Werkstücks (11, 111, 211, 311, 411, 511, 611, 611', 711, 811, 911, 1011, 1111, 1211) verteilt sind und mindestens zwei Reihen paralleler Segmente bilden, wobei die parallelen Segmente (919, 923, 1019, 1023) der ersten Reihe (918, 922, 1018, 1022) zu den parallelen Segmenten (921, 1021, 1025) der zweiten Reihe (920, 1020, 1024) senkrecht sind und unter einem Winkel zusammenlaufen, der ermöglicht, dem mindestens einen Werkstück die Täuschung zu verleihen, dass die ebene Fläche abgeschrägt ist.

6. Verfahren nach Anspruch 1, **dadurch gekennzeichnet, dass** die Blindaussparungen (5) mindestens eine Reihe (1218) von relativ zueinander symmetrisch verteilten Aussparungen (1219) bilden, wobei die mindestens eine Reihe von Aussparungen durch Oberflächen (1232) des mindestens einen Werkstücks (11, 111, 211, 311, 411, 511, 611, 611', 711, 811, 911, 1011, 1111, 1211) umrandet sind, die keinerlei Aussparung aufweisen, um dem mindestens einen Werkstück die Täuschung zu verleihen, dass die ebene Fläche als Relief mit zwei unterschiedlichen Materialien gebildet ist.

7. Verfahren nach einem der vorhergehenden Ansprüche, **dadurch gekennzeichnet, dass** die Blindaussparungen (5) eine Tiefe im Bereich von 2 bis 100 µm aufweisen.

8. Verfahren nach einem der vorhergehenden Ansprüche, **dadurch gekennzeichnet, dass** das Verfahren ferner zwischen Schritt b) und Schritt c) den folgenden Schritt umfasst:
d) Bilden mindestens eines Durchgangslochs in Dickenrichtung des restlichen Substrats, um das mindestens eine Werkstück (11, 111, 211, 311, 411, 511, 611, 611', 711, 811, 911, 1011, 1111, 1211) mit einem Befestigungsmittel (9, 609') zu bilden.

9. Verfahren nach einem der vorhergehenden Ansprüche, **dadurch gekennzeichnet, dass** die Schicht (1) auf Siliciumbasis eine Dicke im Bereich von 50 bis 500 µm aufweist.

10. Verfahren nach einem der vorhergehenden Ansprüche, **dadurch gekennzeichnet, dass** Schritt b) die folgenden Phasen umfasst:
e) Bilden einer Maske (M) mit Öffnungen (4, 8) in der Schicht (1) auf Siliciumbasis, wobei die zum Bilden des mindestens einen Durchgangslochs (6) verwendete Öffnung (8) größer ist als jene (4), die zum Bilden der Blindaussparungen (5) verwendet werden;
f) Gravieren der Schicht auf Siliciumbasis entlang der Öffnungen (4, 8) der Maske (M) mit Hilfe einer anisotropen Einfressung; und
g) Entfernen der Maske (M).

11. Verfahren nach einem der vorhergehenden Ansprüche, **dadurch gekennzeichnet, dass** das Werkstück (11, 111, 211, 311, 411, 511, 611, 611', 711, 811, 911, 1011, 1111, 1211) auf Siliciumbasis einkristallines Silicium, dotiertes einkristallines Silicium, amorphes Silicium, poröses Silicium, polykristallines Silicium, Siliciumnitrid, Siliciumcarbid, Quarz oder Siliciumoxid enthält.

12. Verfahren nach einem der vorhergehenden Ansprüche, **dadurch gekennzeichnet, dass** in derselben Schicht (1) auf Siliciumbasis mehrere Werkstücke (11, 111, 211, 311, 411, 511, 611, 611', 711, 811, 911, 1011, 1111, 1211) gebildet werden.

13. Verfahren nach einem der vorhergehenden Ansprüche, **dadurch gekennzeichnet, dass** das mindestens eine Werkstück (11, 111, 211, 311, 411, 511, 611, 611', 711, 811, 911, 1011, 1111, 1211) ganz oder teilweise ein Zifferblatt, ein Fensterdekor, einen Höhenring, eine Lünette, einen Drücker, eine Krone, einen Gehäuseboden, einen Zeiger, ein Armband, ein Kettenglied, eine Schließe, ein Dekor, eine Schwungmasse oder eine Applikation bildet.

## Claims

1. Method for fabrication of at least one silicon-based component (11, 111, 211, 311, 411, 511, 611, 611', 711, 811, 911, 1011, 1111, 1211) with at least one optical illusion pattern (14, 114, 214, 314, 414, 514, 614, 614', 714, 814, 914, 1014, 1114, 1214), comprising:
a) forming a substrate (10) comprising a silicon-based layer (1);
b) etching at least one hole (6) through the thickness of the silicon-based layer (1) to form, in the same etch, the contour of said at least one component (11,111, 211, 311, 411, 511, 611, 611', 711, 811, 911, 1011, 1111, 1211)and blind recesses (5) in the thickness of the silicon-based layer (1) to form said at least one component (11, 111, 211, 311, 411, 511, 611, 611', 711, 811, 911, 1011, 1111, 1211) with a flat surface comprising said at least one optical illusion pattern (14, 114, 214, 314, 414, 514, 614, 614', 714, 814, 914, 1014, 1114, 1214) making said surface appear not to be flat by being an optical illusion pattern of the faceting and/or chamfering and/or composite component type;
c) releasing said at least one component (11, 111, 211, 311, 411, 511, 611, 611', 711, 811, 911, 1011, 1111, 1211) thereby formed from the substrate (10), said etching step comprising a phase of forming at least one mask with openings (4, 8) on the silicon-based layer (1), the opening (8) used to form said at least one through hole (6) being wider than those (4) used to form the blind recesses (5), in addition to a phase of etching this silicon-based layer by means of at least one anisotropic etch.

2. Method according to the preceding claim, **characterized in that** the blind recesses (5) form at least two series of parallel segments, the first series (118, 218, 518, 718) of parallel segments (119, 219, 519, 719) joining the second series (120, 220, 520, 720) of parallel segments (121, 221, 521, 721) at an angle comprised between 10 and 170°, such that said at least one component gives the illusion that said flat surface comprises two bevelled surfaces forming an edge.

3. Method according to claim 1, **characterized in that** the blind recesses (5) form at least one series (318, 320, 818, 820, 1118) of curved segments (319, 321, 819, 821, 1119) such that said at least one component gives the illusion that said flat surface is domed.

4. Method according to claim 1, **characterized in that** the blind recesses (5) form at least one series (418, 618) of recesses (419, 619) arranged symmetrically in relation to each other, said at least one series of recesses being formed adjacent to a portion (432, 632) wherein the flat surface of the component (11, 111, 211, 311, 411, 511, 611, 611', 711, 811, 911, 1011, 1111, 1211) has no recess, such that said at least one component gives the illusion that said flat surface comprises two bevelled surfaces forming an edge.

5. Method according to claim 1, **characterized in that** the blind recesses (5) are arranged at the periphery of said at least one component (11, 111, 211, 311, 411, 511, 611, 611', 711, 811, 911, 1011, 1111, 1211) and form at least two series of parallel segments, the parallel segments (919, 923, 1019, 1023) of the first series (918, 922, 1018, 1022) being perpendicular to the parallel segments (921, 1021, 1025) of the second series (920, 1020, 1024) and joining at an angle such that said at least one component gives the illusion that said flat surface is chamfered.

6. Method according to claim 1, **characterized in that** the blind recesses (5) form at least one series (1218) of recesses (1219) arranged symmetrically in relation to each other, said at least one series of recesses being bordered by surfaces (1232) of said at least one component (11, 111, 211, 311, 411, 511, 611, 611', 711, 811, 911, 1011, 1111, 1211) having no recess, such that said at least one component gives the illusion that said flat surface is formed in relief with two different materials.

7. Method according to one of the preceding claims, **characterized in that** the depth of the blind recesses (5) is comprised between 2 and 100 *µ*m.

8. Method according to one of the preceding claims, **characterized in that**, between step b) and step c), the method further comprises the following step:
d) forming at least one through hole in the thickness of the rest of the substrate to form said at least one component (11, 111, 211, 311, 411, 511, 611, 611', 711, 811, 911, 1011, 1111, 1211) with a securing means (9, 609').

9. Method according to one of the preceding claims, **characterized in that** the silicon-based layer (1) has a thickness comprised between 50 and 500 *µ*m.

10. Method according to one of the preceding claims, **characterized in that** step b) comprises the following phases:
e) forming a mask (M) with openings (4, 8) on the silicon-based layer (1), the opening (8) used to form said at least one through hole (6) being wider than those (4) used to form the blind recesses (5);
f) etching the silicon-based layer, by means of an anisotropic etch, through the openings (4, 8) in the mask (M);
g) removing the mask (M).

11. Method according to one of the preceding claims, **characterized in that** the silicon-based component (11, 111, 211, 311, 411, 511, 611, 611', 711, 811, 911, 1011, 1111, 1211) contains single crystal silicon, doped single crystal silicon, amorphous silicon, porous silicon, polycrystalline silicon, silicon nitride, silicon carbide, quartz or silicon oxide.

12. Method according to one of the preceding claims, **characterized in that** several components (11, 111, 211, 311, 411, 511, 611, 611', 711, 811, 911, 1011, 1111, 1211) are formed in the same silicon-based layer (1).

13. Method according to one of the preceding claims, **characterized in that** said at least one component (11, 111, 211, 311, 411, 511, 611, 611', 711, 811, 911, 1011, 1111, 1211) forms all or part of a dial, an aperture decoration, a flange, a bezel, a push-piece, a crown, a case back cover, a hand, a bracelet or strap, a link, a clasp, a decoration, an oscillating weight or an applique.
